# EUROPÄISCHE PATENTSCHRIFT

(11) **EP 3 332 480 B1**
(45) Veröffentlichungstag und Bekanntmachung des Hinweises auf die Patenterteilung: **22.05.2019**
(21) Anmeldenummer: 16710136.9
(22) Anmeldetag: 11.03.2016
(51) Int. Cl.: H03K 17/08, H03K 5/08, H02H 9/04, H01L 27/02

(54) **SCHALTUNGSANORDNUNG ZUM SCHUTZ EINER AUS EINEM VERSORGUNGSNETZ ZU BETREIBENDEN EINHEIT GEGEN ÜBERSPANNUNGEN**
CIRCUIT ASSEMBLY FOR PROTECTING A UNIT TO BE OPERATED FROM A SUPPLY NETWORK AGAINST SURGES
CIRCUIT SERVANT À PROTÉGER CONTRE DES SURTENSIONS UNE UNITÉ À FAIRE FONCTIONNER SUR UN RÉSEAU DE DISTRIBUTION ÉLECTRIQUE

(30) Priorität: 07.08.2015 DE 102015010308; 12.02.2016 DE 102016001689
(43) Veröffentlichungstag der Anmeldung: 13.06.2018
(73) Patentinhaber: Dehn + Söhne GmbH + Co. KG, 92318 Neumarkt/Opf. (DE)
(72) Erfinder: BÖHM, Thomas, 92366 Hohenfels (DE); SCHORK, Franz, 90461 Nürnberg (DE)
(74) Vertreter: Kruspig, Volkmar
(86) Internationale Anmeldenummer: PCT/EP2016/055224
(87) Internationale Veröffentlichungsnummer: WO 2017/025202

(56) Entgegenhaltungen:
- EP-A2- 0 397 017
- EP-A2- 2 413 502
- EP-B1- 2 340 593
- US-A1- 2006 214 704
- US-A1- 2011 188 162

## Beschreibung

Die Erfindung betrifft eine Schaltungsanordnung zum Schutz einer aus einem Versorgungsnetz zu betreibenden Einheit gegen Überspannungen mit einem Eingang mit erstem und zweitem Eingangsanschluss, die mit dem Versorgungsnetz in Verbindung stehen, und einem Ausgang, an dem die zu schützende Einheit anschließbar ist, sowie mit einer Schutzschaltung, die zwischen erstem und zweitem Eingangsanschluss vorgesehen ist, um die an ihr anliegende Spannung zu begrenzen, wobei die Schutzschaltung einen Leistungshalbleiter aufweist, gemäß der Lehre der nebengeordneten Ansprüche 1, 2, 3 und 4.

Aus der EP 0 431 215 A1 ist ein Verfahren und eine Anordnung zum Schutz eines abschaltbaren Thyristors vor unzulässiger Überspannung vorbekannt. Gemäß der dortigen Lehre wird die Anodenspannung des abschaltbaren Thyristors in Bezug auf seine Kathodenspannung überwacht und bei Überschreitung eines vorbestimmten Grenzwerts ein Steuersignal generiert, wodurch die am Gate des abschaltbaren Thyristors angeschaltete negative Spannungsquelle abgeschaltet und der Thyristor mittels eines Einschaltkreises eingeschaltet wird.

Die DE 103 38 921 A1 zeigt eine Schaltungsanordnung zum Schutz gegen Stoßspannungen. Gemäß der dortigen Aufgabenstellung liegt das Problem zugrunde, Geräte gegen Stoßspannungen, die z.B. durch Blitzschlag auf einem Spannungsnetz entstehen, zu schützen. Die vorgesehene Schutzschaltung umfasst neben einer Begrenzungsvorrichtung eine Schalteranordnung. Die Schalteranordnung umfasst ein Schaltelement und eine Ansteuerungsschaltung für das Schaltelement, wobei, um eine ausreichend präzise Dimensionierung sicherzustellen, das Schaltelement als Halbleiterbauelement ausgebildet ist. Die Schaltervorrichtung und die Begrenzungsvorrichtung sind seriell angeordnet und so ausgelegt, dass bei einem vorgebbaren ersten Auslösekriterium die Schaltervorrichtung leitend wird und bei einem zweiten Auslösekriterium sperrt.

Aus der DE 10 2010 054 402 A1 ist eine Schaltung zum Schutz eines elektrischen Verbrauchers gegen Überspannungen vorbekannt, wobei zur Erhöhung der Begrenzungsspannung eine zweite Zenerdiode zu einem Shunt-Regler in Reihe geschalten ist. Die zweite Zenerdiode erhöht die übliche Referenzspannung um ihre Durchbruchspannung.

Zum Stand der Technik ist noch auf die EP 2 340 593 B1 zu verweisen, die eine mehrstufige Überspannungsschutzschaltung offenbart, welche sich automatisch auf die anliegende Betriebsspannung einstellen kann. Beim unzulässigen Überschreiten der Betriebsspannung erfolgt eine Begrenzung des Spannungspegels. Bei der diesbezüglich vorbekannten Lösung wird beim Vorliegen einer transienten Überspannung ein dort vorhandener Transistor steilheitsabhängig über einen Hochpass eingeschaltet. Hierzu ist ein Längswiderstand erforderlich, um einen entsprechenden Spannungsabfall zur Steuerung des Transistors zu generieren.

In der US 2011/188162 A1 wird ebenfalls eine Schaltungsanordnung zum Schutz einer aus einem Versorgungsnetz zu betreibenden Einheit gegen Überspannungen offenbart.

Aus dem Vorgenannten ist es daher Aufgabe der Erfindung, eine weiterentwickelte Schaltungsanordnung zum Schutz einer aus einem Versorgungsnetz zu betreibenden Einheit gegen Überspannungen anzugeben, welche auf der Basis einer Schutzschaltung mit Leistungshalbleitern und einem diesbezüglich Clamping-Betrieb des Leistungshalbleiters in der Lage ist, in einfacher Weise Anpassungen des Schutzpegels sowohl abgestuft als auch stufenlos in passiver oder aktiver Weise zu ermöglichen.

Die Lösung der Aufgabe der Erfindung erfolgt jeweils durch die Merkmale der nebengeordneten Ansprüche 1, 2, 3 und 4, wobei die Unteransprüche mindestens zweckmäßige Ausgestaltungen und Weiterbildungen beinhalten.

Die Erfindungslehre geht davon aus, dass durch die Variation der Zenerspannung eines an sich bekannten Clampingelements bei einem Leistungshalbleiter, insbesondere einem IGBT, der als überspannungsbegrenzendes Element eingesetzt wird, der jeweilige Schutzpegel definierbar ist.

Gemäß einer ersten Ausführungsform umfasst die Schutzschaltung einen Leistungshalbleiter, wobei zwischen Kollektor und Gate des Leistungshalbleiters mindestens ein Zenerelement, z.B. eine TVS-Diode, angeschlossen ist, wobei die Zenerspannung eine Clampingspannung für den Leistungshalbleiter ergibt. Erfindungsgemäß sind bei dieser Ausführungsform mehrere Zenerelemente in Reihe geschalten, wobei je nach Momentanwert der Spannung des Versorgungsnetzes mindestens eines der Zenerelemente in den leitenden Zustand übergeht und hiermit eine automatische Anpassung des Schutzpegels erfolgen kann.

Im Fall einer Überspannung mit einer Steilheit, die die eingestellte Ansprechsteilheit übersteigt, steigt die Spannung über dem Widerstand R2 an und es wird der Leistungshalbleiter IGBT aufgesteuert. Die erläuterte Ausführungsform stellt eine Kombination von steilheitsabhängigen Ansprechen mit statischer Schutzpegelanpassung dar.

Bei einer zweiten Ausführungsform der Erfindung ist das Zenerelement Bestandteil eines zwischen Gate und Kollektor des Leistungshalbleiters angeschlossenen Linearreglers, welcher der Spannung des Versorgungsnetzes folgt, um den Schutzpegel auf dem Spannungspegel der Netzspannung zu halten.

Dem Spannungsregler wird gezielt eine Trägheit im Sinne einer Totzeit implementiert, um eine Signalanpassung bei schnellen transienten Überspannungen zu blockieren. Stattdessen fließt ein Strom in Richtung des Gates des Leistungshalbleiters und steuert diesen an.

Bei einer dritten Ausführungsform der Erfindung ist eine Gruppe von, dem Zenerelement parallel zuschaltbaren, weiteren Zenerelementen vorgesehen, welche von einer Treibereinheit aktivierbar sind. Die Treibereinheit steht jeweils mit dem Eingang eines Transistorschalters in Verbindung, dem jeweils eines der weiteren Zenerelemente ausgangsseitig zugeordnet ist.

Bei dieser Ausführungsform wird die Treibereinheit von einem Mikrokontroller angesteuert, welcher den Momentanwert der Spannung des Versorgungsnetzes bestimmt und über die Treibereinheit den jeweils geeigneten Transistorschalter zur Schutzpegelanpassung ansteuert bzw. aktiviert.

Bei der vierten Ausführungsform der erfindungsgemäßen Lehre weist die Schutzschaltung ebenfalls einen Leistungshalbleiter auf, wobei zwischen Kollektor und Gate des Leistungshalbleiters ein Digital-Analog-Wandler angeordnet ist, dessen digitaler Eingang mit dem Ausgang eines Mikrokontrollers in Verbindung steht. Am Mikrokontroller ist eingangsseitig eine Verbindung zum Versorgungsnetz geschaffen, wobei über den analogen Ausgang des Digital-Analog-Wandlers der Schutzpegel der Schaltung vorgebbar ist.

Die Erfindung soll nachstehend anhand von Ausführungsbeispielen sowie unter Zuhilfenahme von Figuren näher erläutert werden.

Hierbei zeigen:
- Fig. 1: eine Prinzipdarstellung der ersten Ausführungsform der Erfindung mit mehreren in Reihe geschalteten Zenerelementen TVS1 bis TVSn im Sinne einer elektronischen Stufenschaltung;
- Fig. 2: eine Prinzipdarstellung einer schaltungsseitigen Ausführungsform mit einem Linearregler als steuerbarer Spannungsquelle zur Einstellung des Schutzpegels;
- Fig. 3: eine Prinzipdarstellung einer Schaltungsanordnung gemäß der dritten Ausführungsform der Erfindung, wobei einem ersten Zenerelement weitere Zenerelemente parallel zuschaltbar sind, wobei diese weiteren Zenerelemente über eine Treibereinheit aktiviert werden können und diesbezüglich Thyristorschalter vorgesehen sind, und
- Fig. 4: ein Blockschaltbild der vierten Ausführungsform der Erfindung mit einer aktiven stufenlosen Schutzpegelanpassung unter Nutzung eines Digital-Analog-Wandlers, welcher zwischen Gate und Kollektor des Leistungshalbleiters (IGBT) geschalten ist und dessen Digitaleingang mit einem Mikrokontroller in Verbindung steht.

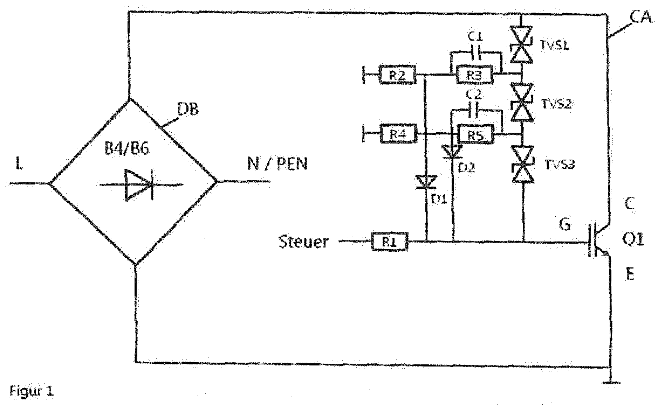

Bei der Ausführungsform nach Fig. 1 umfasst die Schutzschaltung einen Leistungshalbleiter IGBT. Zwischen Kollektor und Gate des IGBT sind mehrere Zenerelemente TVS1 bis TVSn vorgesehen. An den Knotenpunkten der Reihenschaltung sind schaltungstechnische Mittel vorgesehen, um je nach aktuellem Momentanwert der Netzspannung eines oder mehrere der Zenerelemente TVS1 bis TVSn leitend werden zu lassen, um somit den Schutzpegel zu bestimmen. Die Schutzschaltung wird wie auch bei den übrigen Ausführungsbeispielen über eine mit dem Eingang L; N in Verbindung stehende Diodenbrücke DB gespeist, so dass negative und positive Überspannungsimpulse erkenn- und ableitbar sind. Ebenfalls ist bei allen Ausführungsformen der Leistungshalbleiter IGBT als aktives Überspannungsschutzelement ausgestaltet.

Es kommt demnach zu einem steilheitsabhängigen Ansprechen, wobei eine statische Schutzpegelanpassung bei der Ausführungsform nach Fig. 1 vorgesehen ist.

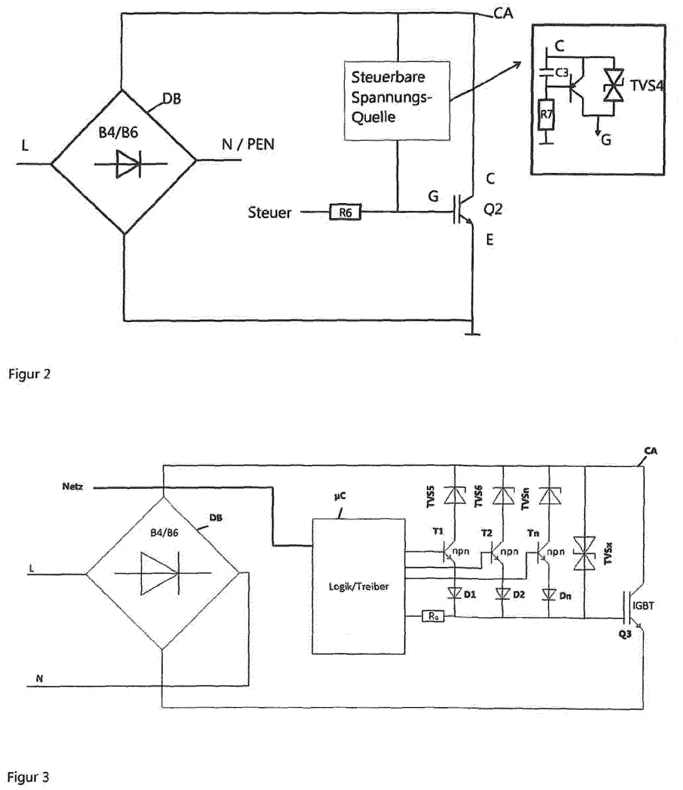

Bei der Ausführungsform nach Fig. 2 wird der Schutzpegel durch eine steuerbare Spannungsquelle SQ eingestellt. Die steuerbare Spannungsquelle ist, wie in der Detaildarstellung nach Fig. 2 gezeigt, bevorzugt als Linearregler ausbildbar, dessen Ausgang mit dem Zenerelement TVS in Verbindung steht.

Der zwischen Kollektor und Gate angeschlossene Linearregler folgt der Spannung des Netzes L; N, so dass der Schutzpegel immer auf dem Pegel der Netzspannung liegt. Eine Aktivierung dieser Schaltung erfolgt bei transienten Spannungsänderungen. Über den Regler wird gezielt eine Totzeit implementiert, um eine Signalanpassung bei schnellen transienten Überspannungen zu blockieren. Vielmehr fließt stattdessen ein Strom in Richtung des Gates des Leistungshalbleiters, um diesen anzusteuern.

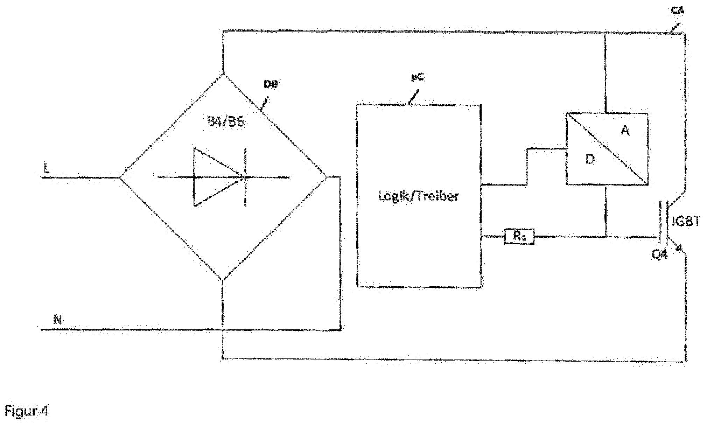

Die Darstellungen nach den Fig. 3 und 4 zeigen die Möglichkeit, durch Einsatz eines intelligenten Treibers, insbesondere unter Nutzung eines Mikrokontrollers µC, den Schutzpegel an die aktuelle Netzspannung anzupassen, indem jeweils das Zenerelement bzw. dessen Eigenschaften variiert werden. Dies ist durch die in der Fig. 3 gezeigte erste Variante und durch die in der Fig. 4 zweite Variante möglich.

Bei der Variante nach Fig. 3 bestimmt der Mikrokontroller µC den Momentanwert der Netzspannung L; N und schaltet eines der Zenerelemente TVS1; TVS2; TVSn zwischen Kollektor und Gate des IGBT. Beispielhafte Schutzpegel sind durch die Spannungsangaben neben den Elementen TVS1 bis TVSn angedeutet. Das Schalten der jeweiligen Elemente TVS1 bis TVSn erfolgt mittels Transistoren T1 bis Tn, deren Basis jeweils mit dem Ausgang des Mikrokontrollers µC und einer entsprechenden, auch in den Mikrokontroller integrierbaren Treibereinheit in Verbindung steht.

Die Funktionsweise gemäß der Darstellung nach Fig. 3 stellt sich wie folgt dar.

Wenn die Schaltungsanordnung am Netz liegt, ist zunächst der Schutzpegel auf den höchsten maximalen Wert, z.B. 1 kV voreingestellt. Nach der Ermittlung des Momentanwerts der Netzspannung wird über den Mikrokontroller Cµ und den Treiber eine geeignete der Schutzstufen aktiviert. Wenn ein Überspannungsereignis auftritt, wird der Stoßstrom mit Hilfe des IGBT abgeleitet und danach wird die Schaltungsanordnung wieder auf die höchste Schutzpegelstufe voreingestellt. Nach dem Überspannungsereignis wird erneut der Momentanwert der Netzspannung bestimmt und die Schutzstufe an die Netzspannung angepasst.

Wenn keine Überspannungsereignisse auftreten und festgestellt wird, dass sich die Netzspannung langsam erhöht, z.B. 1 V/min, wird dies vom Mikrokontroller erfasst und es wird der Schutzpegel dann entsprechend automatisch langsam erhöht oder erniedrigt.

Die vierte Ausführungsform gemäß der Darstellung nach Fig. 4 geht von dem Gedanken aus, zwischen Kollektor und Gate des IGBT einen Digital-Analog-Wandler DA zu schalten, welcher wiederum von einem Mikrokontroller angesteuert wird. Bei dieser Variante besteht die Möglichkeit, eine Reaktion und Anpassung des Schutzpegels ausschließlich auf der Basis der integrierten Netzspannung einzustellen und anzupassen.

## Patentansprüche

1. Schaltungsanordnung zum Schutz einer aus einem Versorgungsnetz zu betreibenden Einheit gegen Überspannungen mit einem Eingang mit erstem und zweitem Eingangsanschluss (L; N), die mit dem Versorgungsnetz in Verbindung stehen, und einem Ausgang (A), an dem die zu schützende Einheit anschließbar ist, sowie mit einer Schutzschaltung, die zwischen erstem und zweitem Eingangsanschluss (L; N) vorgesehen ist, um die an ihr liegende Spannung zu begrenzen, wobei die Schutzschaltung einen Leistungshalbleiter (IGBT) aufweist, weiterhin zwischen Kollektor und Gate des Leistungshalbleiters mindestens ein Zenerelement (TVS) angeschlossen ist, wobei die Zenerspannung eine Clampingspannung für den Leistungshalbleiter (IGBT) ergibt,
**dadurch gekennzeichnet, dass**
mehrere Zenerelemente (TVS1 bis TVSn) in Reihe geschalten sind, wobei an den Knotenpunkten der Reihenschaltung schaltungstechnische Mittel vorgesehen sind, die so konfiguriert sind, dass je nach Momentanwert der Spannung des Versorgungsnetzes eines oder mehrere der Zenerelemente in den leitenden Zustand übergehen und hiermit eine automatische Anpassung des Schutzpegels der Schutzschaltung erfolgt.

2. Schaltungsanordnung zum Schutz einer aus einem Versorgungsnetz zu betreibenden Einheit gegen Überspannungen mit einem Eingang mit erstem und zweitem Eingangsanschluss (L; N), die mit dem Versorgungsnetz in Verbindung stehen, und einem Ausgang (A), an dem die zu schützende Einheit anschließbar ist, sowie mit einer Schutzschaltung, die zwischen erstem und zweitem Eingangsanschluss (L; N) vorgesehen ist, um die an ihr liegende Spannung zu begrenzen, wobei die Schutzschaltung einen Leistungshalbleiter (IGBT) aufweist, weiterhin zwischen Kollektor und Gate des Leistungshalbleiters mindestens ein Zenerelement (TVS) angeschlossen ist, wobei die Zenerspannung eine Clampingspannung für den Leistungshalbleiter (IGBT) ergibt,
**dadurch gekennzeichnet, dass**
das Zenerelement (TVS) Bestandteil eines zwischen Gate und Kollektor des Leistungshalbleiters (IGBT) angeordneten Linearreglers (SQ) ist, welcher der Spannung des Versorgungsnetzes folgt, um den Schutzpegel auf dem Spannungspegel der Netzspannung zu halten.

3. Schaltungsanordnung zum Schutz einer aus einem Versorgungsnetz zu betreibenden Einheit gegen Überspannungen mit einem Eingang mit erstem und zweitem Eingangsanschluss (L; N), die mit dem Versorgungsnetz in Verbindung stehen, und einem Ausgang (A), an dem die zu schützende Einheit anschließbar ist, sowie mit einer Schutzschaltung, die zwischen erstem und zweitem Eingangsanschluss (L; N) vorgesehen ist, um die an ihr anliegende Spannung zu begrenzen, wobei die Schutzschaltung einen Leistungshalbleiter (IGBT) aufweist, weiterhin zwischen Kollektor und Gate des Leistungshalbleiters mindestens ein Zenerelement (TVS) angeschlossen ist, wobei die Zenerspannung eine Clampingspannung für den Leistungshalbleiter (IGBT) ergibt,
**dadurch gekennzeichnet, dass**
eine Gruppe von dem Zenerelement (TVS) parallel zuschaltbaren weiteren Zenerelementen (TVS1 bis TVSn) vorgesehen ist, welche von einer Treibereinheit aktivierbar sind, wobei die Treibereinheit jeweils mit dem Eingang eines Transistorschalters (T1 bis Tn) in Verbindung steht, dem jeweils eines der weitere Zenerelemente (TVS1 bis TVSn) zugeordnet ist, wobei die Treibereinheit von einem Mikrokontroller (µC) angesteuert wird, welcher den Momentanwert der Spannung des Versorgungsnetzes bestimmt und über die Treibereinheit jeweils geeignete Transistorschalter (T1 bis Tn) zur Schutzpegelanpassung aktiviert.

4. Schaltungsanordnung zum Schutz einer aus einem Versorgungsnetz zu betreibenden Einheit gegen Überspannungen mit einem Eingang mit erstem und zweitem Eingangsanschluss (L; N), die mit dem Versorgungsnetz in Verbindung stehen, und einem Ausgang (A), an dem die zu schützende Einheit anschließbar ist, sowie mit einer Schutzschaltung, die zwischen erstem und zweitem Eingangsanschluss vorgesehen ist, um die an ihr liegende Spannung zu begrenzen, wobei die Schutzschaltung einen Leistungshalbleiter (IGBT) aufweist,
**dadurch gekennzeichnet, dass**
zwischen Kollektor und Gate des Leistungshalbleiters (IGBT) ein Digital-Analog-Wandler (DA) angeordnet ist, dessen digitaler Eingang mit dem Ausgang eines Mikrokontrollers (µC) in Verbindung steht, welcher eingangsseitig am Versorgungsnetz angeschlossen ist, wobei über den analogen Ausgang des Digital-Analog-Wandlers (DA) der Schutzpegel der Schaltung auf Basis der integrierten Spannung des Versorgungsnetzes vorgebbar ist.

5. Schaltungsanordnung nach einem der vorangegangenen Ansprüche,
**dadurch gekennzeichnet, dass**
die Schutzschaltung über eine mit dem Eingang in Verbindung stehende Diodenbrücke (DB) gespeist wird, so dass negative und positive Überspannungsimpulse ableitbar sind.

## Claims

1. A circuit assembly for protecting a unit to be operated from a supply network against surges, comprising an input having a first and a second input connection (L; N), which are connected to the supply network, and an output (A) to which the unit to be protected can be connected, and a protective circuit provided between the first and the second input connections (L; N) in order to limit the voltage applied thereto, said protective circuit comprising a power semiconductor (IGBT), furthermore at least one Zener element (TVS) being connected between the collector and gate of the power semiconductor, the Zener voltage yielding a clamping voltage for the power semiconductor (IGBT),
**characterized in that**
a plurality of Zener elements (TVS1 to TVSn) is connected in series, wherein circuit means are provided at the nodal points of the series connection which are configured such that, depending on the instantaneous value of the voltage of the supply network, one or more of the Zener elements enter the conducting state and thus the protective level of the protective circuit is automatically adapted.

2. A circuit assembly for protecting a unit to be operated from a supply network against surges, comprising an input having a first and a second input connection (L; N), which are connected to the supply network, and an output (A) to which the unit to be protected can be connected, and a protective circuit provided between the first and the second input connections (L; N) in order to limit the voltage applied thereto, said protective circuit comprising a power semiconductor (IGBT), furthermore at least one Zener element (TVS) being connected between the collector and gate of the power semiconductor, the Zener voltage yielding a clamping voltage for the power semiconductor (IGBT),
**characterized in that**
the Zener element (TVS) is an integral part of a linear regulator (SQ) connected between the gate and collector of the power semiconductor (IGBT) and following the voltage of the supply network so as to maintain the protective level on the voltage level of the supply voltage.

3. A circuit assembly for protecting a unit to be operated from a supply network against surges, comprising an input having a first and a second input connection (L; N), which are connected to the supply network, and an output (A) to which the unit to be protected can be connected, and a protective circuit provided between the first and the second input connections (L; N) in order to limit the voltage applied thereto, said protective circuit comprising a power semiconductor (IGBT), furthermore at least one Zener element (TVS) being connected between the collector and gate of the power semiconductor, the Zener voltage yielding a clamping voltage for the power semiconductor (IGBT),
**characterized in that**
a group of further Zener elements (TVS1 to TVSn) that can be connected in parallel to the Zener element (TVS) is provided, which can be actuated by a driver unit, wherein the driver unit is in each case in connection with the input of a transistor switch (T1 to Tn) to which in each case one of the further Zener elements (TVS1 to TVSn) is associated, wherein the driver unit is controlled by a microcontroller (µC) which determines the instantaneous value of the voltage of the supply network and actuates respective appropriate transistor switches (T1 to Tn) via the driver unit to adapt the protective level.

4. A circuit assembly for protecting a unit to be operated from a supply network against surges, comprising an input having a first and a second input connection (L; N), which are connected to the supply network, and an output (A) to which the unit to be protected can be connected, and a protective circuit provided between the first and the second input connections in order to limit the voltage applied thereto, said protective circuit comprising a power semiconductor (IGBT),
**characterized in that**
between the collector and the gate of the power semiconductor (IGBT), a digital-to-analog converter (DA) is placed, the digital input thereof being in connection with the output of a microcontroller (µC), which at its input side is connected to the supply network, wherein the protective level of the circuit can be defined via the analog output of the digital-to-analog converter (DA) based on the integrated voltage of the supply network.

5. The circuit assembly according to any one of the preceding claims,
**characterized in that**
the protective circuit is fed via a diode bridge (DB) connected to the input so that negative and positive overvoltage pulses may be discharged.

## Revendications

1. Ensemble de circuit pour protéger contre des surtensions une unité à faire fonctionner à partir d'un réseau d'alimentation, comportant une entrée pourvue d'une première et d'une seconde borne d'entrée (L ; N) qui sont en liaison avec le réseau d'alimentation, et une sortie (A) à laquelle peut être connectée ladite unité à protéger, ainsi qu'un circuit de protection qui est prévu entre la première et la seconde borne d'entrée (L ; N) pour limiter la tension appliquée à celui-ci, le circuit de protection comprenant un semi-conducteur de puissance (IGBT), et au moins un élément Zener (TVS) est connecté entre le collecteur et la grille du semi-conducteur de puissance, la tension de Zener donnant une tension de serrage pour le semi-conducteur de puissance (IGBT),
**caractérisé en ce que**
plusieurs éléments Zener (TVS1 à TVSn) sont connectés en série, des moyens de commutation étant prévus aux points de noeud du circuit en série, qui sont configurés de telle sorte qu'en fonction de la valeur momentanée de la tension du réseau d'alimentation, un ou plusieurs des éléments Zener se mettent dans l'état passant et qu'ainsi il se produit une adaptation automatique du niveau de protection du circuit de protection.

2. Ensemble de circuit pour protéger contre des surtensions une unité à faire fonctionner à partir d'un réseau d'alimentation, comportant une entrée pourvue d'une première et d'une seconde borne d'entrée (L ; N) qui sont en liaison avec le réseau d'alimentation, et une sortie (A) à laquelle peut être connectée ladite unité à protéger, ainsi qu'un circuit de protection qui est prévu entre la première et la seconde borne d'entrée (L ; N) pour limiter la tension appliquée à celui-ci, le circuit de protection comprenant un semi-conducteur de puissance (IGBT), et au moins un élément Zener (TVS) est connecté entre le collecteur et la grille du semi-conducteur de puissance, la tension de Zener donnant une tension de serrage pour le semi-conducteur de puissance (IGBT),
**caractérisé en ce que**
l'élément Zener (TVS) fait partie d'un régleur linéaire (SQ) agencé entre la grille et le collecteur du semi-conducteur de puissance (IGBT), régleur qui suit la tension du réseau d'alimentation pour maintenir le niveau de protection au niveau de la tension de réseau.

3. Ensemble de circuit pour protéger contre des surtensions une unité à faire fonctionner à partir d'un réseau d'alimentation, comportant une entrée pourvue d'une première et d'une seconde borne d'entrée (L ; N) qui sont en liaison avec le réseau d'alimentation, et une sortie (A) à laquelle peut être connectée ladite unité à protéger, ainsi qu'un circuit de protection qui est prévu entre la première et la seconde borne d'entrée (L ; N) pour limiter la tension appliquée à celui-ci, le circuit de protection comprenant un semi-conducteur de puissance (IGBT), et au moins un élément Zener (TVS) est connecté entre le collecteur et la grille du semi-conducteur de puissance, la tension de Zener donnant une tension de serrage pour le semi-conducteur de puissance (IGBT),
**caractérisé en ce que**
il et prévu un groupe d'autres éléments Zener (TVS1 à TVSn) susceptibles d'être branchés en parallèle audit élément Zener (TVS), qui sont activables par une unité de pilotage, l'unité de pilotage étant en connexion avec l'entrée respective d'un commutateur à transistor (T1 à Tn) auquel est associé respectivement l'un des autres éléments Zener (TVS1 à TVSn), l'unité de pilotage étant pilotée par un microcontrôleur (µC) qui détermine la valeur momentanée de la tension du réseau d'alimentation et qui active le commutateur à transistor respectif approprié (T1 à Tn) via l'unité de pilotage pour adapter le niveau de protection.

4. Ensemble de circuit pour protéger contre des surtensions une unité à faire fonctionner à partir d'un réseau d'alimentation, comportant une entrée pourvue d'une première et d'une seconde borne d'entrée (L ; N) qui sont en liaison avec le réseau d'alimentation, et une sortie (A) à laquelle peut être connectée ladite unité à protéger, ainsi qu'un circuit de protection qui est prévu entre la première et la seconde borne d'entrée (L ; N) pour limiter la tension appliquée à celui-ci, le circuit de protection comprenant un semi-conducteur de puissance (IGBT),
**caractérisé en ce que**
un convertisseur numérique-analogique (DA) est agencé entre le collecteur et la grille du semi-conducteur de puissance (IGBT), dont l'entrée numérique est en connexion avec la sortie d'un microcontrôleur (µC) qui est connecté du côté entrée au réseau d'alimentation, le niveau de protection du circuit pouvant être défini via la sortie analogique du convertisseur numérique-analogique (DA) en se basant sur la tension intégrée du réseau d'alimentation.

5. Ensemble de circuit selon l'une des revendications précédentes,
**caractérisé en ce que**
le circuit de protection est alimenté via un pont de diodes (DB) en connexion avec l'entrée, permettant de dissiper des impulsions de surtension négatives et positives.
